# EUROPEAN PATENT APPLICATION

(11) **EP 4 553 525 A1**
(43) Date of publication of application: **14.05.2025**
(21) Application number: 23209407.8
(22) Date of filing: 13.11.2023
(51) Int. Cl.: G01R 31/58, G01R 31/67

(54) **METHOD AND DEVICE FOR FUNCTIONAL TESTING OF CABLE HARNESSES, IN PARTICULAR HIGH-VOLTAGE CABLE HARNESSES**

(71) Applicant: Lisa Dräxlmaier GmbH, 84137 Vilsbiburg (DE)
(72) Inventor: Safta, Ovidiu-Vasile, Satu Mare (RO); Wolf, Vlad-Teofil, Vilsbiburg (DE)

(57) **Abstract**

The invention refers to a method and device for functional testing of cable harnesses, in particular high-voltage cable harnesses, comprising a test system (2) which is equippable with a cable harness (A, B, C), with a cable harness (A, B, C) having a plurality of components to be tested, and with the test system (2) having at least one test device (6, 7) with which different, preferably automatically running, functional tests, in particular electrical tests and/or sealing tests as functional tests, are executable for the components of a cable harness (A, B, C) to be tested. According to the invention, the test system (2) comprises several test nests, preferably of essentially the equal design, which are sequentially equipped with a cable harness (A, B, C), in particular by one and the same operator, so that at least one functional test is performed at least temporarily simultaneously on several cable harnesses (A, B, C).

## Description

### Technical Field

The invention refers to a method and a device for functional testing of cable harnesses, in particular high-voltage cable harnesses.

### Prior Art

When several individual cables, via which energy or information is transmitted, are bundled together, this is referred to as a cable harness. Such cable harnesses are always used when many individual cables are required, as is the case, for example, in connection with on-board networks of aircraft, ships, railroads, commercial vehicles (trucks, buses, etc.) and especially in automotive construction. Low-voltage cable harnesses are regularly used for voltage levels below 60V, while high-voltage cable harnesses are used for voltage levels above 60V. The latter include, for example, charging cables of -E-vehicles that connect the charging socket of charging stations with the on-board charging system. High-voltage cable harnesses are used as traction cable that connect high-voltage batteries to the power electronics, to name just one further example. For such cable harnesses, reliable electric contacting is therefore essential to guarantee their electrical functions, so that a wide range of requirements are placed on the electrical connectors of cable harnesses in particular. For this reason, the cable harnesses are subjected to electrical functional testing to ensure that they meet all of the required electrical properties.

Furthermore, the cable harnesses must also be sealed against dirt and moisture, as the penetration of these can lead to malfunctions in the electrical connection and in the connected electronics. Therefore, the sealing test of the connectors of cable harnesses is of particular importance.

Furthermore, cable harnesses, for example in vehicles, regularly have to pass tightly through an opening provided in a wall in order to seal the opening against the ingress of moisture and dirt, for example. Such a seal is made, for example, by means of a lead-through component, such as a grommet, which is usually made of an elastomer material and is molded directly onto the cable harness. During the manufacturing process of such a grommet as a lead-through component, for example, tolerance-related misalignment may occur, or cracks may appear that impair the sealing function of the grommet. Accordingly, in practice such lead-through components of a cable harness must also be tested for lead-through sealing.

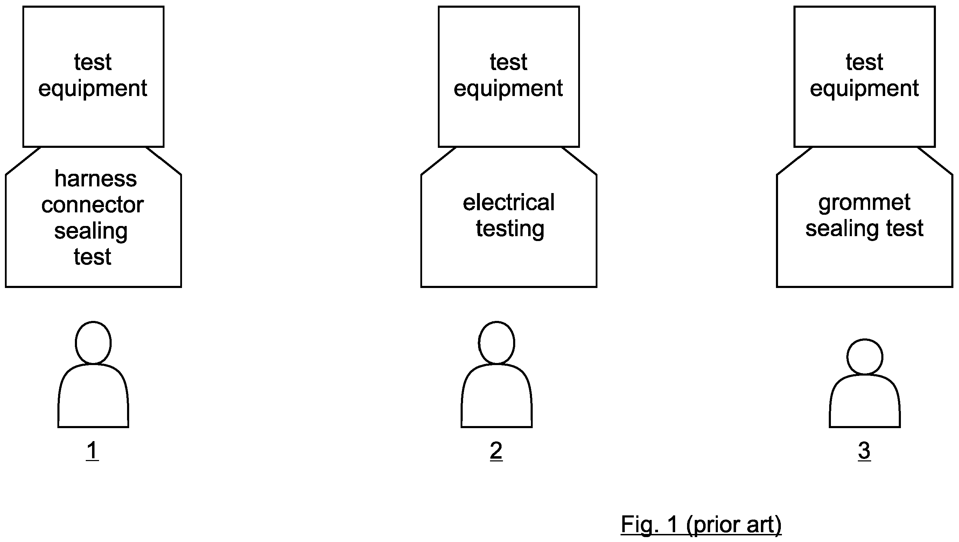

These exemplary functional tests for high-voltage cable harnesses in particular, i.e. connector sealing, lead-through sealing, electrical properties, are according to the prior art carried out by means of separate test stations, as shown schematically in Figure 1, from which a separate test station for performing connector sealing tests (left) on connectors of a cable harness, a separate test station for performing electrical tests (center) on connectors of a cable harness and a separate station for performing lead-through sealing tests (right) on lead-through components, e.g. grommets, of a cable harness are arranged. Different operators work at each of the test stations, performing the individual functional tests on cable harnesses. Depending on the type of test, each of these automatically executed functional tests takes between 20 and 60 seconds, during which the operator is not active. All in all, this results in a relatively high expenditure of time, personnel and costs when performing the functional tests.

### Description of the invention

It is an object of the invention to provide a method and a device for functional testing of cable harnesses, in particular high-voltage cable harnesses, with which the time, personnel and costs involved in carrying out the necessary functional tests can be significantly reduced in a technically simple and functionally reliable manner.

This object is solved by means of the independent claims. Preferred embodiments are specified in the dependent claims, in the description and in the accompanying figures.

The invention refers to a method for functional testing of cable harnesses, in particular high-voltage cable harnesses, comprising a test system which is equippable with a cable harness, with a cable harness having a plurality of components to be tested, and with the test system having at least one test device with which different, preferably automatically running, functional tests, in particular electrical tests and/or sealing tests as functional tests, are executable for the components of a cable harness to be tested. According to the invention, the test system comprises several test nests, preferably of essentially the equal design, which are sequentially equipped with a cable harness, in particular by one and the same operator, so that at least one functional test is performed at least temporarily simultaneously on several cable harnesses.

As a result, the times when the operator is not active because an automatic functional test is running at a test nest can be used to equip another test nest with a cable harness to be tested, which significantly reduces the time, personnel and costs involved in performing the functional tests. In addition, this type of process management results in an advantageous compact combination of several test devices, for example in a single test device or test board, whereby shorter distances between the individual test stations can be achieved and less installation space is also required.

According to a particularly preferred specific embodiment, at the beginning of a functional testing of several cable harnesses, in a first step a first cable harness to be tested is arranged in a first test nest and the functional testing for the first cable harness is started, so that at least one functional test is performed on the first cable harness. During this functional testing for the first cable harness, a second cable harness to be tested is arranged in a second test nest, preferably by the same operator, and the functional testing for the second cable harness is started. As a result, at least one functional test is also performed on the first cable harness and thus, at least temporarily, at least one functional test is performed simultaneously on the first cable harness and on the second cable harness. With this specific process management with two test nests, the above-mentioned advantages are achieved to a particular extent and it is ensured that the idle times for an operator are significantly reduced, which leads to the desired time and cost savings in conjunction with compact and functionally reliable test devices and test procedures.

A particularly advantageous method is one in which, during functional testing for the second cable harness, a third cable harness to be tested is arranged in a third test nest and functional testing for the third cable harness is started, so that at least one functional test is performed on the third cable harness. In this respect, at least one functional test is performed simultaneously, at least temporarily, on the second cable harness and on the third cable harness, and possibly also on the first cable harness. With such a third test nest, the working time of an operator can be organized even more effectively, so that of course the advantages mentioned above also apply here. In principle, a fourth, fifth or further test nest(s) could also be provided, whereby the number of test nests to be provided, which can be operated by a single operator, is determined by the amount of time required by the operator to perform the individual tasks in conjunction with the respective required functional tests. As a rule of thumb, the longer the functional tests take for a complete cable harness, the more test nests can theoretically be provided, since there is then more time available for an operator to be inactive. Other parameters that influence the number of test nests are, for example, the need to perform any reconnecting works that may be required for the individual cable harnesses during functional testing, to name just one example. It also plays a role that, according to a particularly preferred method, each cable harness is removed from the associated test nest after the functional tests intended for it have been performed and that the test nest can then be equipped again with a new cable harness. In this respect, test systems that have three or four, at most five test nests and can be operated by one operator have proven themselves in practice.

In principle, there are various possibilities for the technical functional testing of cable harnesses, of which, however, the electrical functional tests and sealing tests mentioned at the beginning are of particular importance. Accordingly, according to a particularly preferred method, at least one electrical test device is provided for performing at least one electrical functional test, and at least one sealing test device is provided for performing at least one sealing test as a functional test. This means that at least one of these functional tests can be carried out at least temporarily simultaneously on several cable harnesses.

The several cable harnesses to be tested, which are preferably formed by cable harnesses of essentially identical construction, advantageously each have several connectors and at least one lead-through component (for example a grommet) as components to be tested, according to a particularly preferred specific embodiment. In this case, the at least one electrical test device has plug-in connections for the connectors of a cable harness to be tested with regard to its electrical properties, while the sealing test device has plug-in connections for the connectors of a cable harness to be tested for connector sealing and at least one lead-through connection for the lead-through component of a cable harness to be tested for lead-through sealing. This ensures that at least one of these functional tests can be performed at least temporarily simultaneously on several cable harnesses.

For a particularly compact design of the test system, it can be provided that the plug-in connections of the electrical test device simultaneously form the plug-in connections for the sealing test device, so that the connector sealing test can be performed on a cable harness, at least temporarily, simultaneously with the at least one electrical functional test. Such a connector sealing test can, for example, be a pneumatic test in which the connectors are pressurized with compressed air (negative or positive pressure) and either pressure difference or volumetric flow rate is measured. This makes it possible to achieve advantageous component and function integration, which in particular also contributes to a desired compact design. In addition, and this is a particular advantage of this embodiment, each cable harness with all its components to be tested can be connected to the associated test devices at the start of a functional testing, so that all the functional tests to be performed for the cable harness can run in parallel or one after the other, and the cable harness is not removed until all the functional tests for the components to be tested have been performed.

Alternatively, in the case of separate plug connections on the electrical test device and on the sealing test device, it can be provided that the connector sealing test for a specific cable harness is performed with a time delay, preferably after the at least one electrical functional test for this cable harness. The latter is particularly advantageous if, for example, technical difficulties could arise with the combined plug connections for the electrical test device and the sealing test device due to the specific technical design of a cable harness.

In such a specific method in which at least one electrical test device and at least one sealing test device are used, it can be provided, for example, according to a particularly advantageous specific method, that at the start of a functional test, in a first step, a first cable harness to be tested is arranged in a first test nest, the connectors of the first cable harness being connected to the plug-in connections of the electrical test device and the lead-through component of the first cable harness being connected to the lead-through connection of the sealing test device. After the first cable harness has been connected in this way, an electrical test, in particular a sequential low- and high-voltage test as an electrical test, and the lead-through sealing test for the first cable harness can be performed at least temporarily simultaneously. During the performance of the electrical test and/or the lead through sealing test for the first cable harness, which preferably run automatically, a second cable harness to be tested is arranged in a second test nest, wherein the connectors of the second cable harness are connected to the plug-in connections of the electrical test device and the lead through component of the second cable harness is connected to the lead through connection of the sealing test device. After the second cable harness has been connected in this way, an electrical test, in particular as a sequential low-voltage and high-voltage test, and the lead-through sealing test for the second cable harness can be performed at least temporarily simultaneously. Preferably, the electrical test and/or the lead-through sealing test for the second cable harness is or are also performed at least temporarily simultaneously with a functional test, for example a connector sealing test, for the first cable harness. The advantages resulting from this have already been explained in detail in connection with the general procedure for functional testing of two cable harnesses. They apply here in an analogous manner.

This also applies to a further preferred specific embodiment in which, while the electrical test and/or the lead-through sealing test for the second cable harness is being carried out, a third cable harness to be tested is arranged in a third test nest, the connectors of the third cable harness being connected to the plug-in connections of the electrical test device and the lead-through component being connected to the lead-through connection of the sealing test device. After the third cable harness has been connected in this way, an electrical test, in particular as a sequential low-voltage and high-voltage test, and the lead-through sealing test for the third cable harness can be performed at least temporarily simultaneously. Here, too, it is preferred that the electrical test and/or the lead-through sealing test for the third cable harness is or are also carried out at least temporarily simultaneously with a functional test, for example a connector sealing test, for the second cable harness, if necessary even at least temporarily simultaneously with a functional test for the first and the second cable harnesses.

An electrical test is particularly preferred as an electrical functional test on the cable harnesses. Particularly in in the case of high-voltage cable harnesses, such an electrical test is preferably carried out as a sequential low-voltage and high-voltage test.

More specifically, the low voltage test includes, for example:
- A simple connection test for low-voltage and high-voltage cable harnesses;
- An advanced four wire connection test only for high-voltage cable harnesses and shields from shielded high-voltage cable harnesses;
- A short circuit testing to avoid wrong connections;
- Other functional tests for electronics like LEDs, communication protocols, resistors, actuators.

And the high-voltage test, for example, includes:
- A dielectric breakdown strength test with multiple operating voltage: e.g. 4,3kV DC;
- An insulation resistance test with 1 kV DC.

In this context, it is particularly preferred that the electrical test is part of a test procedure that can be carried out by means of the electrical test device, with which it is determined in a first test step whether the high-voltage cable harness to be tested fulfils the properties tested with the low-voltage test and with which it is determined in a second test step, which follows the first test step in terms of time, whether the cable harness to be tested fulfils the properties tested with the high-voltage test.

According to another particularly preferred embodiment, a memory device is provided which - for the transmission of data acquired by means of the at least one test device and/or for the transmission of data to the at least one test device - is coupled with the at least one test device. This can be done by cable and/or wirelessly. With such a memory device, which can be designed for example as a database, all test results can then be stored as well as the predefined inspection or test parameters. This enables seamless documentation of the functional testing.

It is further preferred that the test nests each have a detection device by means of which the cable harness to be tested is identified. Such a detection device can, for example, be an optical detection device, such as a camera, which identifies the cable harness to be tested by means of a scanner function. Of course, RFID technology can also be used at any time. By means of the detection device, an identification signal is then preferably generated, which can be transmitted to the memory device, in which the start of the test for the respective cable harness newly arranged in a test nest and to be tested is registered. RFID is particularly advantageous because in the automotive environment, test data must be stored for 15 years as a standard and thus a server somewhere always has the results ready, at least for each individual identifiable test item. This means that if a customer has a problem with a cable harness, the test data can be retrieved at a later date. That's why each cable harness at the test station should preferably have a barcode or RFID with a unique ID where all the data are assigned.

Furthermore, according to a particularly preferred embodiment, it can be provided that the test and/or inspection results for a cable harness are stored in the memory device after completion of all the functional tests provided for this cable harness and the cable harness is then removed from the test nest. This can be done, for example, by removing the cable harness from the test nest and placing a new cable harness to be tested in the test nest.

The above referenced object is also solved by means of a device for carrying out a method for functional testing of cable harnesses, in particular high-voltage harnesses, comprising a test system which is equippable with a cable harness, with a cable harness having a plurality of components to be tested, whereby the test system comprises at least one test device with which different, preferably automatically running, functional tests, in particular electrical tests and/or sealing tests as functional tests, are executable for the components of a cable harness to be tested. According to the invention the test system comprises a plurality of test nests, preferably of essentially the equal design, which are sequentially equippable with a cable harness, in particular by one and the same operator, with the test system being designed and configured to perform at least one functional test at least temporarily simultaneously on several cable harnesses.

The advantages resulting from said device are identical to those of the method and thus apply here in an analogous manner. In this respect, reference is made to the explanations given previously in order to avoid repetition.

### Short description of figures

In the following, an advantageous embodiment of the invention is explained in more detail by way of example with reference to the accompanying figures. It shows:
- Figure 1: The performance of functional tests on cable harnesses in separate test stations according to prior art,
- Figure 2a: a schematic and exemplary structure of a device according to the invention for carrying out a method according to the invention for functional testing of cable harnesses, in particular of high-voltage cable harnesses, in connection with a first method step of the functional testing of several cable harnesses according to the invention,
- Figure 2b: the set-up according to Figure 2a in connection with a second method step of a functional testing of several cable harnesses according to the invention,
- Figure 2c: the set-up according to Figures 2a and 2b in connection with a third method step of a functional testing of several cable harnesses according to the invention,
- Figure 3: a schematic, chronologically structured flow chart for an exemplary method sequence of a functional testing of several cable harnesses according to the invention.

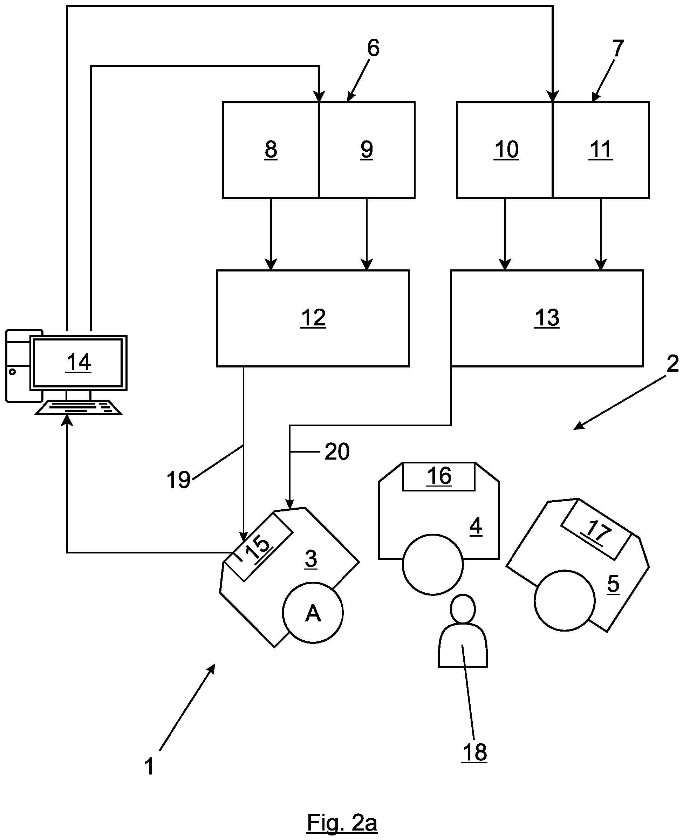

Figure 2a only shows an exemplary and schematic structure of a device 1 for carrying out a method for functional testing of cable harnesses. This device 1 has a test system 2, which in this example has three test nests, namely a first test nest 3, a second test nest 4 and a third test nest 5.

The test system 2 further comprises an electrical test device 6 and a sealing test device 7, the electrical test device 6 being equipped with test equipment 8 for a low-voltage test and with test equipment 9 for a high-voltage test. The sealing test device 7 is equipped with test equipment 10 for a connector sealing test and with test equipment 11 for a lead through sealing test.

The electrical test device 6 and the sealing test device 7 can, for example, be part of a common test device or test board.

As shown in Figure 2a, the electrical test device 6 has a matrix 12 having plug-in connections for the connectors of a cable harness to be tested for its electrical properties. Furthermore, the sealing test device 7, again shown only extremely schematically in the form of a matrix 13, has plug-in connections for the connectors of a cable harness to be tested for connector sealing and a lead-through connection for the lead-through component of a cable harness to be tested for lead-through sealing. The lead through component can be a grommet, for example. For electrical testing, for example, a relay box (relay matrix) is used as a matrix. For the sealing tests, valves can be used analogously, for example, to switch between the test devices.

Further, the device 1 comprises a memory device 14 signal-transmittingly coupled by means of the test devices 6, 7 for transmitting the data acquired by means of the test devices 6, 7 and/or for transmitting the data to the test devices 6, 7.

The test nests 3, 4, 5 each have a detection device 15 16 and 17, which is designed, for example, as an optical detection device, for example as a camera with scanner function, by means of which the specific cable harness to be tested in the respective test nest is identified, for example by detecting a barcode or the like. The detection device 15, 16, 17 can generate an identification signal that is transmitted to the memory device, in which the start of the test for a respective cable harness newly arranged in the test nest and to be tested is then registered.

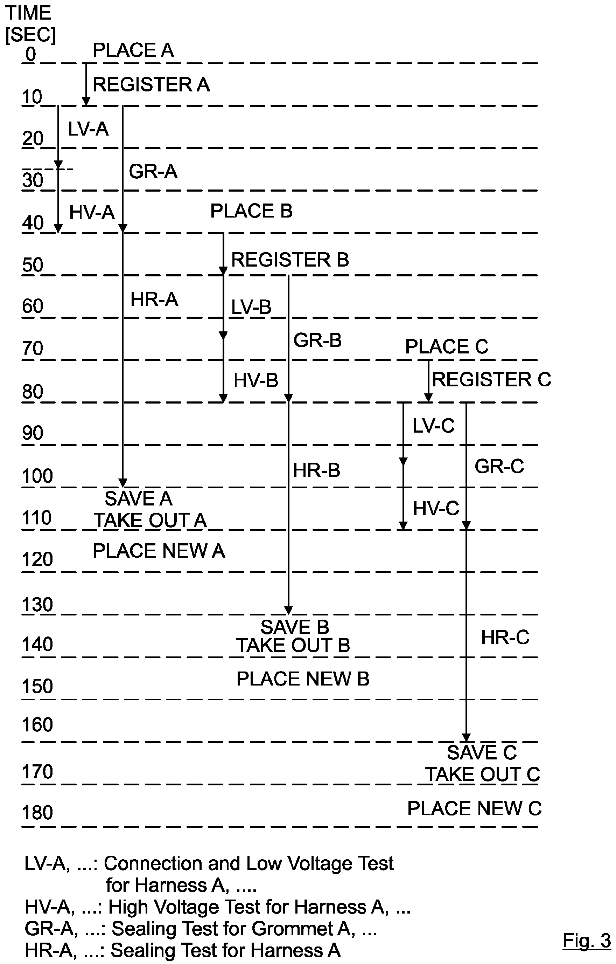

In the following, Figures 2a to 2c in conjunction with Figure 3 are used to explain in more detail an exemplary procedure for a method according to the invention, whereby the cable harnesses to be tested are designated here with the reference signs A, B and C, are preferably of identical design and each have several connectors and a grommet as a lead-through component:

Figure 2a shows how an operator 18 places the first cable harness A to be tested in the first test nest 3, where the detection device 15 automatically registers the cable harness A and transmits a message to the memory device 14 that functional testing is starting in the first test nest 3. Here, the connectors of the first cable harness are connected to the plug-in connections of the electrical test device 6 and the lead through component of the first cable harness A is connected to the lead through connection of the sealing test device 7. As shown in Figure 2a in conjunction with Figure 3, the first cable harness A is now subjected to an electrical test as an electrical functional test and, essentially simultaneously, also to a lead-through sealing test. For example, if cable harness A is a high voltage cable harness, the electrical test may consist of a simple and advanced connection test and a sequential low and high voltage test, with the low voltage test preferably including a short circuit test to avoid incorrect connections and possibly other functional tests for electronics such as LEDs, communication protocols, resistors, actuators, and with the high voltage test preferably including a dielectric breakdown test with multiple operating voltages: e.g. 4,3kV DC. This is shown in Figure 2a with arrows 19 and 20, where reference sign 19 denotes the electrical test and reference sign 20 the lead through sealing test. In Figure 3, the abbreviations mean what follows:

| | |
|---|---|
| LV-A: | Connection Test and Low-Voltage Test for harness A |
| HV-A: | High-Voltage Test for harness A |
| GR-A: | Grommet Sealing Test for harness A |
| HR-A: | Harness Connector Sealing Test for harness A |

LV-A and HV-A together form the electrical test. The same applies to the cable harnesses B and C, which in this example are also high voltage cable harnesses.

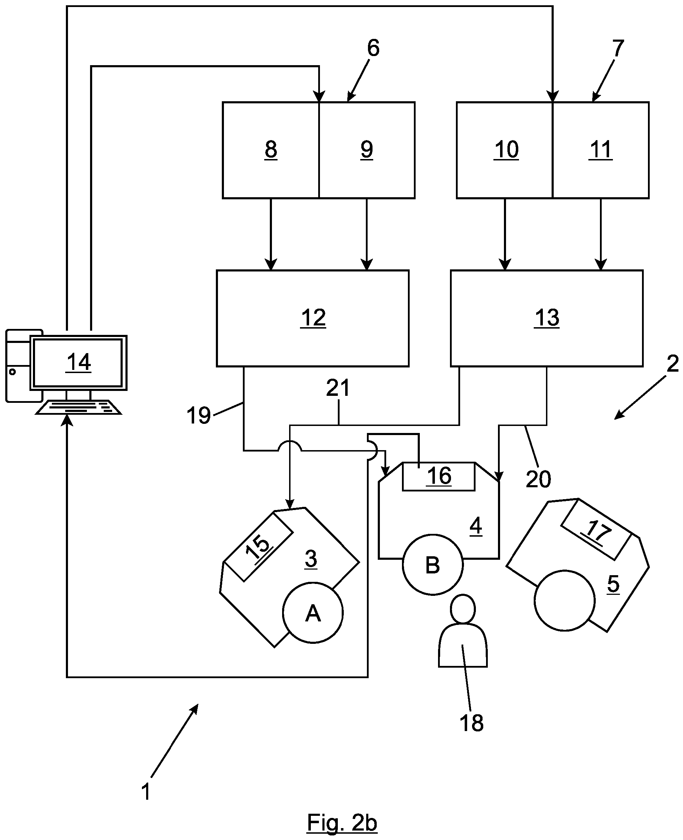

As shown in Figure 2b, the operator 18 can now insert the second cable harness B to be tested into the second test nest 4 in parallel with the functional tests 19, 20 running automatically in the first test nest 3. In the second test nest 4, the second cable harness B is then registered by means of the detection device 16 and a signal is sent to the memory device 14 that functional testing is starting in the second test nest 4.

As shown in Figure 2b, in the first test nest 3 the electrical test and also the lead-through sealing test can be completed and the connector sealing test 21 can be performed for the first cable harness A, while in parallel in the second test nest 4 the electrical test 19 and the lead-through sealing test 20 are already being performed for the second cable harness B.

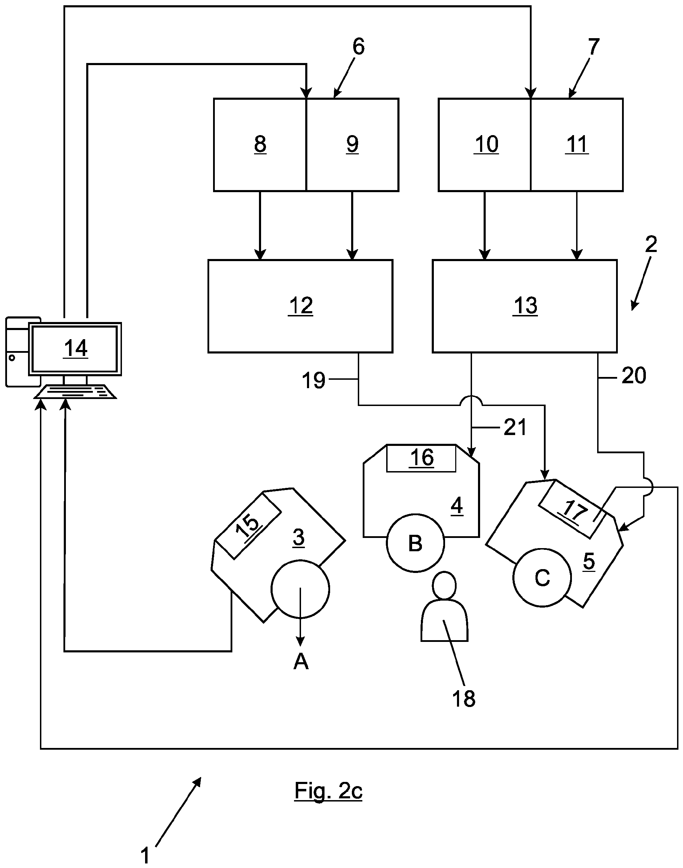

As can be seen from Figure 2c, the operator 18 can now insert a third cable harness C to be tested into the third test nest 5 in parallel with the functional tests running automatically in the first and second test nests 3, 4. In this third test nest 5, the cable harness C to be tested is detected by the detection device 17 and an identification signal is generated, which in turn is transmitted to the memory device 14, in which the start of the test for the cable harness C arranged in the third test nest 5 and to be tested is registered.

The electrical test is then started for the third cable harness C. At the same time, the lead-through sealing test for the third cable harness C begins in the third test nest 5.

In the example shown here, see also Figure 3, the functional testing for the cable harness A in the first test nest 3 is then also completed, so that the test and/or inspection results for the cable harness A can then be stored in the memory device (see SAVE A in Figure 3) and the cable harness A can be removed from the test nest 3 (see TAKE OUT A in Figure 3). The operator 18 can then insert a new cable harness to be tested into the first test nest 3 (see PLACE NEW A in Figure 3) and the functional testing in the first test nest 3 starts again. At the same time, the electrical test and the lead-through sealing test have already been performed and completed in the second test nest 4 for the second cable harness B to be tested there, so that the connector sealing test 21 is now performed for the cable harness B in the second test nest 4. As soon as this is completed, the test and/or inspection results for the second cable harness B are also transmitted to the memory device 14 and stored there (SAVE B) and the cable harness B is removed (TAKE OUT B) and a new cable harness to be tested is placed there (PLACE NEW B).

In the meantime, the electrical test and the lead-through sealing test have been carried out and completed in the third test nest 5, so that the connector sealing test (not shown) is now already being carried out there, after the completion of which the test and/or inspection results for the third cable harness C are in turn transmitted to the memory device 14 (SAVE C), the cable harness C can be removed from the third test nest 5 (TAKE OUT C) and a new cable harness to be tested can then be placed there (PLACE NEW C).

The above example shows how cycle times can be significantly reduced by performing at least part of the functional tests on several cable harnesses simultaneously. It should be understood that the sequence shown in Figure 3 is merely to be understood as an example and naturally depends on the specific tests to be carried out in each case.

### List of reference signs

- 1: device for carrying out a method for functional testing of cable harnesses
- 2: test system 2
- 3: first test nest
- 4: second test nest
- 5: third test nest
- 6: electrical test device
- 7: sealing test device
- 8: test equipment for a low-voltage test
- 9: test equipment for a high-voltage test
- 10: test equipment for a connector sealing test
- 11: test equipment for a lead through sealing test
- 12: matrix
- 13: matrix
- 14: memory device
- 15: detection device
- 16: detection device
- 17: detection device
- 18: operator
- 19: electrical test
- 20: lead through sealing test
- 21: connector sealing test

## Claims

1. Method for functional testing of cable harnesses, in particular high-voltage cable harnesses, comprising a test system (2) which is equippable with a cable harness (A, B, C), with a cable harness (A, B, C), having a plurality of components to be tested, and with the test system (2) having at least one test device (6, 7) with which different, preferably automatically running, functional tests, in particular electrical tests and/or sealing tests as functional tests, are executable for the components of a cable harness (A, B, C) to be tested, **characterized in that** the test system (2) comprises a plurality of test nests (3, 4, 5) which are sequentially equipped with a cable harness (A, B, C), so that at least one functional test is performed at least temporarily simultaneously on several cable harnesses (A, B, C).

2. Method according to claim 1, **characterized**
**in that**, at the start of a functional testing of a plurality of cable harnesses (A, B, C), in a first step a first cable harness (A) to be tested is arranged in a first test nest (3) and the functional testing for the first cable harness (A) is started, so that at least one functional test is performed on the first cable harness (A),
**in that** during the functional testing for the first cable harness (A) a second cable harness (B) to be tested is arranged in a second test nest (4) and the functional testing for the second cable harness (B) is started, so that at least one functional test is performed on the second cable harness (B) and, at least temporarily, at least one functional test is performed simultaneously on the first cable harness (A) and on the second cable harness (B).

3. Method according to claim 2, **characterized in that** during the functional testing for the second cable harness (B) a third cable harness (C) to be tested is arranged in a third test nest (5) and the functional testing for the third cable harness (C) is started, so that at least one functional test is carried out on the third cable harness (C), such that at least one functional test is performed at least temporarily simultaneously on the second cable harness (B) and on the third cable harness (C), preferably on the first cable harness (A), on the second cable harness (B) and on the third cable harness (C).

4. Method according to any one of the preceding claims, **characterized in that** each cable harness (A, B, C) is removed from the assigned test nest (3, 4, 5) after performing the functional tests intended for it, which test nest (3, 4, 5) is then equippable with a new cable harness.

5. Method according to any one of the preceding claims, **characterized**
**in that** at least one electrical test device (6) is provided for performing at least one electrical functional test, and
**in that** at least one sealing test device (7) is provided for performing at least one sealing test as a functional test,
so that at least one of these functional tests is performed at least temporarily simultaneously on several cable harnesses (3, 4, 5).

6. Method according to claim 5, **characterized**
**in that** the multiple cable harnesses (A, B, C) to be tested, preferably formed by cable harnesses (A, B, C) of essentially identical structure, each comprise multiple connectors and at least one lead-through component as components to be tested,
**in that** the electrical test device (6) comprises plug-in connections for the connectors of a cable harness (A, B, C) to be tested with regard to its electrical properties,
**in that** the sealing test device (7) comprises plug-in connections for the connectors of a cable harness (A, B, C) to be tested for connector sealing and at least one lead-through connection for the lead-through component of a cable harness (A, B, C) to be tested for lead-through sealing,
so that at least one of these functional tests is performed at least temporarily simultaneously on several cable harnesses (A, B, C).

7. Method according to claim 5 or 6, **characterized in that** an electrical test is performed as an electrical functional test, preferably a sequential low-voltage and high-voltage test as an electrical functional test, by means of the electrical test device (6), preferably such that the electrical test is a component of a test procedure which is carried out by means of the electrical test device (6), with which it is determined in a first test step whether the high-voltage cable harness (A, B, C) to be tested fulfils the properties tested with the low-voltage test and with which it is determined in a second test step, which follows the first test step in terms of time, whether the cable harness (A, B, C) to be tested fulfils the properties tested with the high-voltage test..

8. Method according to any one of the preceding claims, **characterized in that** a memory device (14) is provided, which is coupled to the at least one test device (6, 7) for the transmission of data acquired by means of the at least one test device (6, 7) and/or for the transmission of data to the at least one test device (6, 7).

9. Method according to any one of the preceding claims, **characterized in that** the test nests (3, 4, 5) each have a detection device (15, 16, 17), preferably an optical detection device, by means of which the cable harness (A, B, C) to be tested is identified, preferably such that the detection device (15, 16, 17) generates an identification signal which is transmitted to the memory device (14) in which the start of the test for the cable harness (A, B, C) which is newly arranged in the test nest and is to be tested is registered.

10. Device for carrying out a method for functional testing of cable harnesses, in particular according to a method according to any one of the preceding claims, comprising a test system (2) which is equippable with a cable harness (A, B, C), with a cable harness (A, B, C) having a plurality of components to be tested, whereby the test system (2) comprises at least one test device (6, 7) with which different, preferably automatically running, functional tests, in particular electrical tests and/or sealing tests as functional tests, are executable for the components of a cable harness (A, B, C) to be tested, **characterized in that** the test system (2) comprises a plurality of test nests (3, 4, 5) which are sequentially equippable with a cable harness (A, B, C), the test system (2) being designed and configured to perform at least one functional test at least temporarily simultaneously on several cable harnesses (A, B, C).
